(19) Europäisches Patentamt
European Patent Office
Office européen des brevets

(11) **EP 0 504 840 B1**

(12) **EUROPÄISCHE PATENTSCHRIFT**

(45) Veröffentlichungstag und Bekanntmachung des Hinweises auf die Patenterteilung:
**29.10.1997 Patentblatt 1997/44**

(51) Int. Cl.$^6$: **C04B 35/00**, H01L 39/24

(21) Anmeldenummer: **92104686.8**

(22) Anmeldetag: **18.03.1992**

(54) **Wismut enthaltendes supraleitendes Material und Verfahren zu seiner Herstellung**

Superconducting material containing bismuth and process for its production

Matériau supraconducteur contenant du bismuth et son procédé de préparation

(84) Benannte Vertragsstaaten:
**AT BE CH DE DK ES FR GB GR IT LI LU NL SE**

(30) Priorität: **19.03.1991 DE 4108869**

(43) Veröffentlichungstag der Anmeldung:
**23.09.1992 Patentblatt 1992/39**

(73) Patentinhaber: **HOECHST AKTIENGESELLSCHAFT 65926 Frankfurt am Main (DE)**

(72) Erfinder:
• **Hettich, Bernhard, Dr.
W-6239 Eppstein/Taunus (DE)**
• **Majewski, Peter, Dr.
W-7062 Rudersberg (DE)**
• **Schulze, Klaus, Dr.
W-7000 Stuttgart 80 (DE)**
• **Petzow, Günter, Prof.
W-7022 Leinfelden-Echterdingen (DE)**

(56) Entgegenhaltungen:
**FR-A- 2 654 719**

• **PATENT ABSTRACTS OF JAPAN vol. 14, no. 562 (C-788)13. Dezember 1990 & JP-A-2 243 519 ( CHODENDO HATSUDEN K ) 27. September 1990**
• **MATERIALS SCIENCE FORUM Bd. 62-64, 27. April 1990, Seiten 87 - 88 V.S. KRAVCHENKO 'Synthesis of Bismuth-Containing High-Tc Ceramics'**

## Beschreibung

Die Erfindung betrifft ein oxidkeramisches supraleitendes Material, das Wismut, Strontium, Kalzium und Kupfer enthält, und ein Verfahren zu seiner Herstellung.

Das Vierstoffsystem $Bi_2O_3$-SrO-CaO-CuO zeichnet sich durch das Auftreten von drei supraleitenden Phasen aus, nämlich $Bi_2Sr_2CuO_6$("2201-Phase" oder "Raveau-Phase" mit $T_c$ = 9 K), $Bi_2Sr_2CaCu_2O_8$ ("2212-Phase" mit $T_c$ = 90 K) und $Bi_2Sr_2Ca_2Cu_3O_{10}$ ("2223-Phase" mit $T_c$ = 110 K). Die Identifizierung der 2223-Phase als wichtigste supraleitende Phase geht auf J.L. Tallon et al., Nature 333 (1988) Seite 153 zurück. Man hat daher versucht, phasenreine 2223-Proben herzustellen. Dies ist auf pulvermetallurgischem Wege jedoch schwierig. Es ist ferner bekannt, daß die 2223-Phase eine eigenständige Verbindung mit einem Stabilitätsbereich zwischen T = 850 - 890°C darstellt und besonders dann beständig ist, wenn der Wismutanteil des Systems höher ist als es der idealen Zusammensetzung 2223 entspricht. (K. Schulze et al., Zeitschrift für Metallkunde, Bd. 81 (1990) Seite 836).

Der vorliegenden Erfindung lag daher die Aufgabe zugrunde, ein neues Wismut enthaltendes oxidkeramisches supraleitendes Material zu schaffen, das sich durch einen besonders hohen Anteil an 2223-Phase auszeichnet, und ein neues Verfahren anzugeben, mit dem es auf einfache Art und Weise möglich ist, bei der Herstellung von Wismut enthaltendem oxidkeramischem supraleitendem Material gezielt eine möglichst hohe Ausbeute von Anteilen an 2223-Phase zu erreichen.

Diese Aufgabe wird durch ein Material der eingangs genannten Gattung gelost, das eine Bruttozusammensetzung $Bi_yCa_2Sr_2Cu_3O_x$ besitzt, wobei y eine Zahl von 2,35 bis 2,6 bedeutet und x etwa 10 bis 12 ist, das eine Sprungtempertatur $T_c$ oberhalb von 105 K und einen Phasenanteil der Phase $Bi_2Sr_2Ca_2Cu_3O_x$ von mindestens 70 Vol.-% aufweist. Vorzugsweise liegt y im Bereich von 2,45 bis 2,55 und der Phasenanteil der Phase $Bi_2Sr_2Ca_2Cu_3O_x$ oberhalb von 85 Vol.-%, insbesondere oberhalb von 90 Vol.-%.

Die Aufgabe der Erfindung wird ferner gelost durch ein Verfahren zur Herstellung eines Wismut enthaltenden supraleitenden Materials mit einem Phasenanteil der Phase $Bi_2Sr_2Ca_2Cu_3O_x$ von mindestens 70 Vol.-%, bei dem die Oxide oder die Oxidvorläufer von Wismut, Strontium, Kalzium und Kupfer über eine Zeitspanne von mehreren Stunden auf einer Temperatur im Bereich von 850 bis 890°C gehalten werden und bei dem die folgenden Atomverhältnisse eingehalten werden:

Bi : Cu ≥ 2,35 : 3
Ca : Sr = 0,9 bis 1,50
$\Sigma$ (Sr+Ca) : Cu = 4,2 : 3 bis 4 : 3,33
Bi : $\Sigma$ (Sr+Ca) = 2,35 : 4 bis 3,1 : 4.

Vorzugsweise wird das Atomverhältnis von Ca : Sr in dem Oxidgemisch im Bereich von 0,95 bis 1,35 gehalten, insbesondere im Bereich von 0,95 bis 1,05. In einer weiteren bevorzugten Ausführungsform der Erfindung beträgt das Atomverhältnis $\Sigma$ (Sr+Ca) : Cu in dem Oxidgemisch 4,1 : 3 bis 4 : 3,1, insbesondere 4 : 3 bis 4 : 3,1. Erfindungsgemäß weiterhin bevorzugt in dem Oxidgemisch das Atomverhältnis Bi : $\Sigma$ (Sr+Ca) innerhalb des Bereiches von 2,4 : 4 bis 2,6 : 4, insbesondere von 2,45 : 4 bis 2,55 : 4. Anstelle der Oxide von Strontium, Calcium und Kupfer kann man auch andere Salze der genannten Elemente einsetzen, die bei den Reaktionstemperaturen zu den Oxiden zerfallen, sogenannte Oxidvorläufersalze. Typische Beispiele für derartige Salze sind die Carbonate oder die Nitrate.

Es ist vorteilhaft, wenn man das Gemisch der Oxide zunächst mindestens 2 Stunden bei 700 - 800°C erhitzt. Nach dem Abkühlen wird das geglühte Gemisch homogenisiert und dann auf Temperaturen von 850 bis 890°C erhitzt. Noch besser ist es, wenn man das bei 700 bis 800°C erhaltene Produkt nach dem Homogenisieren nochmals mindestens 2 Stunden bei 800 - 860°C erhitzt, nach dem Abkühlen nochmals homogenisiert und dann erst auf Temperaturen von 860 bis 890°C erhitzt.

Wenn man den Ansatz, der auf Temperaturen von 860 bis 890°C erhitzt wird, vorher zu einem Formkörper verpreßt, so gelingt es überraschend, supraleitende Formkörper, beispielsweise in Tablettenform, zu erhalten.

Das Abkühlen von 860 bis 890°C auf Raumtemperatur geht vorzugsweise langsam vor sich. Günstig ist es, wenn man direkt innerhalb des Ofens abkühlen läßt. Dabei haben sich Abkühlungsgeschwindigkeiten von 2 bis 10°/min am besten bewährt.

Der Anteil an supraleitender 2223-Phase in dem supraleitenden Material wird erfindungsgemäß besonders hoch, wenn man mindestens 50 Stunden bei 700 bis 800°C erhitzt und insbesondere zusätzlich nochmal 50 Stunden bei 830°C erhitzt. Das Erhitzen wird vorzugsweise in Gegenwart von Sauerstoff, insbesondere in Luft, durchgeführt. Die Behandlung des Gemisches bei Temperaturen von 850 bis 890°C soll sich vorzugsweise über einen Zeitraum von mehr als 24 Stunden erstrecken, insbesondere im Bereich von 40 bis 200 Stunden, besonders bevorzugt von 60 bis 150 Stunden, und findet ebenfalls in Gegenwart von Sauerstoff statt. Insgesamt werden bei niedrigeren Sintertemperaturen (T<880°C) längere Glühzeiten (t>150h) benötigt, um vergleichbare Resultate bezüglich des Volumenanteiles der 2223-Phase zu erreichen, und umgekehrt. Eine Temperatur von 890 °C soll allerdings nicht überschritten werden.

Die nach dem erfindungsgemäßen Verfahren erhaltenen Produkte enthalten circa 92 Vol.-% 2223-Phase, 2 bis 3 Vol.-% 2212-Phase und ca. 5 Vol.-% an Kupferoxid plus Erdalkalicupraten.

Die Erfindung wird durch die nachfolgenden Ausführungsbeispiele näher erläutert, ohne jedoch auf die konkret dargestellten Ausführungsformen beschränkt zu sein.

Beispiel 1

Als Ausgangsmaterial wurde $Bi_2O_3$, $SrCO_3$, $CaCO_3$ und CuO (Reinheit 99 %) verwendet. Es wurde eine Probe mit der Einwaage $Bi_{2,5}Sr_2Ca_2Cu_3O_x$ hergestellt. Das homogenisierte Ausgangspulver wurde nach folgendem Programm calciniert:

a) 60 Stunden halten bei 790°C an Luft und
b) 2 x 60 Stunden halten bei 830°C an Luft.

Jeweils zwischen den Glühungen wurden die Pulver in einem Achatmörser homogenisiert. Nach wiederholtem Homogenisieren wurden aus den Pulvern zylindrische Körper von ca. 1,5 cm Länge und 4 bis 5 mm Durchmesser gepreßt. Die Preßlinge wurde 90 Stunden bei 885 bis 890°C gesintert.

Die qualitative Phasenidentifikation erfolgte mittels:

- Optischer Mikroskopie im polarisierten Auflicht (Gefügeanalyse),
  Gerät: Zeiss AXIOMAT
  Vergrößerung: 25- bis 100fach.
- Messung der Röntgenbeugung an pulverisierten Proben (XRD),
  Meßgerät: Pulverdiffraktometer PW 1050 der Firma Phillipps (40 kV, 25 mA),
  Strahlung: Cu $K_a$, $\lambda$ = 0,154056 nm mit Graphit Monochromator.
- Rasterelektronenmikroskop (REM)
  Gerät: Cambridge Muster S 200 (15 kV, 1,10 mA)
  Vergrößerung: 200- bis 2000fach,
  mit angeschlossenem Energiedispersivem Röntgenemissionsanalysengerät (EDX) oder (EDAX),
  Typ: AN 10 000, Firma Link
  Auflösung: circa 1 $\mu$m.

Die qualitative Phasenidentifikation ergab als Probenbestandteile unterschiedliche Mengen von 2212- und 2223-Phase, Kupferoxid und Kuprat $(Ca,Sr)_2CuO_3$.

Die quantitative Bestimmung der Volumenprozentanteile der einzelnen Phasen erfolgte nach folgendem Verfahren:

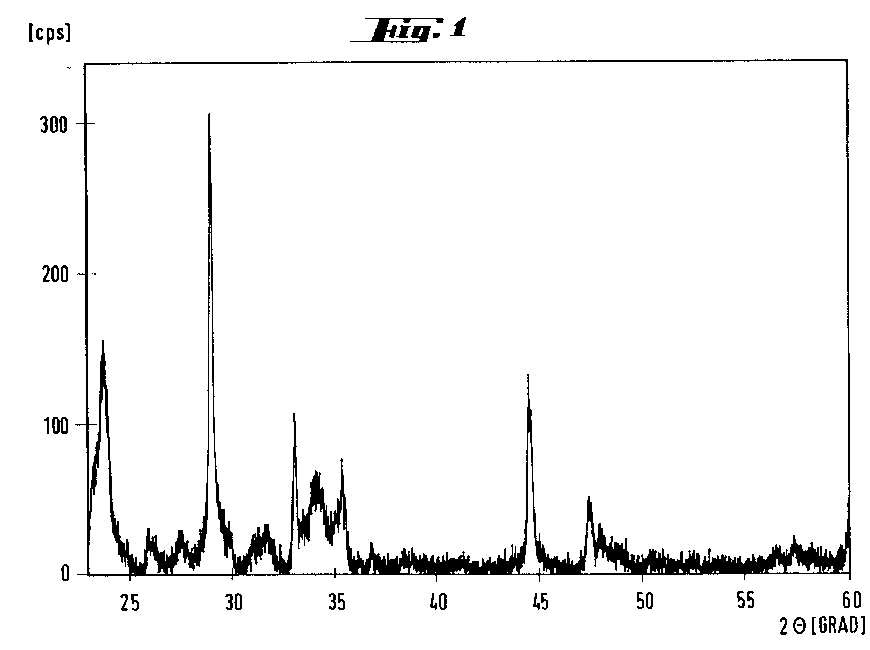

a) Im Auflichtmikroskop wurden die Phasenanteile der 2212-, der 2223-Phase, der Cuprate und von Kupferoxid mit dem Punktzählverfahren ermittelt.
b) Die 2212- und 2223-Phasen können im Auflichtmikroskop nicht voneinander unterschieden werden. Die Volumenprozentanteile der 2212- und 2223-Phase wurden daher mit Hilfe der Röntgenbeugung (XRD) nach H. Kirschner, Einführung in die Röntgenfeinstrukturanalyse, Vieweg-Verlag (1980), Kap. 1 bis 4, ermittelt. Dazu wurden die Flächenintegrale des jeweils stärksten Beugungsreflexes der 2212-Phase (hkl 115,2 $\theta$ = 27,5° ) und der 2223-Phase ( hkl = 117,2 $\theta$ = 28,78°) ins Verhältnis gesetzt (Fig. 1). Aus a) und b) ergeben sich die Volumenprozentanteile der genannten Verbindungen mit einer Genauigkeit von 2 bis 5 %, bezogen auf den jeweiligen Wert.

c) Der supraleitende Volumenanteil der beiden supraleitenden Phasen 2212 und 2223 in % wurde durch Messung der magnetischen Suszeptibilität nach W. Buckel, Supraleitung, Verlag Chemie (1990), und Gerthsen et al., Physik, Springer Verlag (1977), der Proben in einer Induktivitätsmeßbrücke bei:

$$v = 10 \text{ kHz}, T = 3 \text{ bis } 300 \text{ K}$$

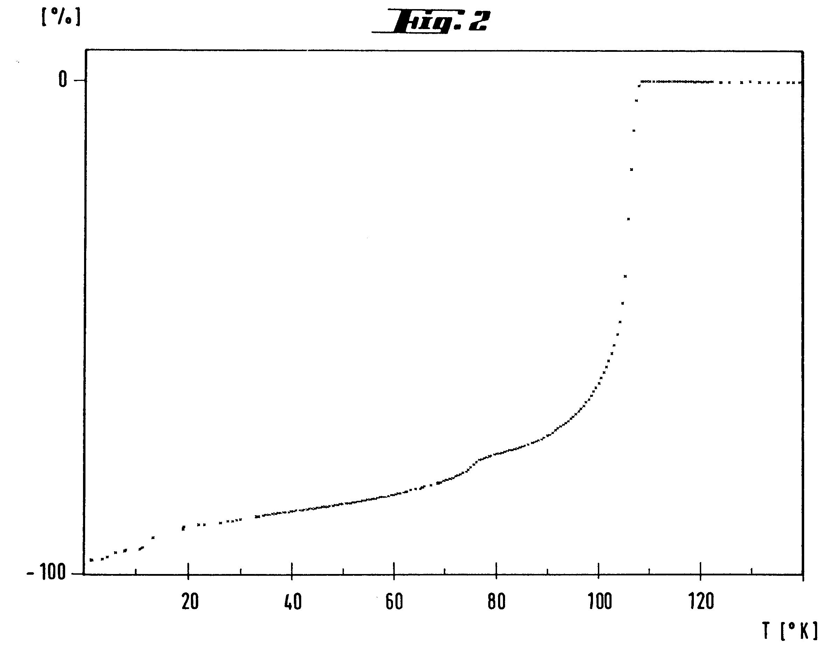

ermittelt. Der ideale Diamagnet, der zu 100 % supraleitend wäre, verdrängt das externe Magnetfeld zu 100 %. Dieser Zustand ist definitionsgemäß gleich -1 und dimensionslos. Der partielle Sättigungsgrad des diamagnetischen Signals mit sinkender Temperatur (eine Zahl zwischen 0 und -1) wird in % ausgedrückt. Extrapolation auf die Ordinate in den Figuren 2 bis 4 ergibt die jeweiligen Anteile der supraleitenden Phasen in den jeweiligen Proben.

Der Anteil an 2223-Phase in dem Material nach Beispiel 1 wurde mit beiden Methoden übereinstimmend zu 92 Vol.-% bestimmt.

Beispiel 2

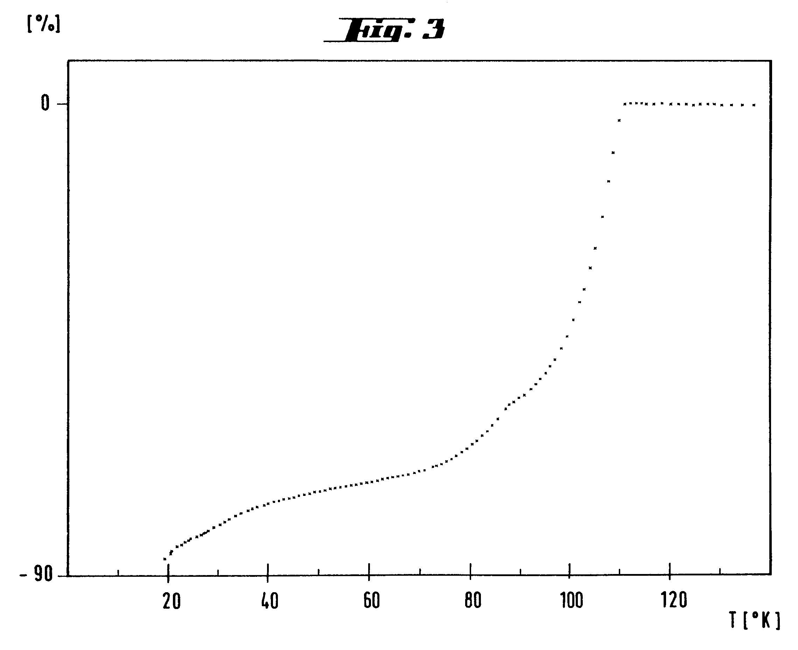

Das Beispiel 1 wird wiederholt, jedoch mit der Ausgangszusammensetzung $Bi_{2,6}Sr_{2,3}Ca_{1,9}Cu_3O_x$. Der Anteil an 2223-Phase beträgt jedoch nur 70 Vol.-%, wie aus der Messung der magnetischen Suszeptibilität (Fig. 3) hervorgeht.

Beispiel 3 (Vergleichsbeispiel)

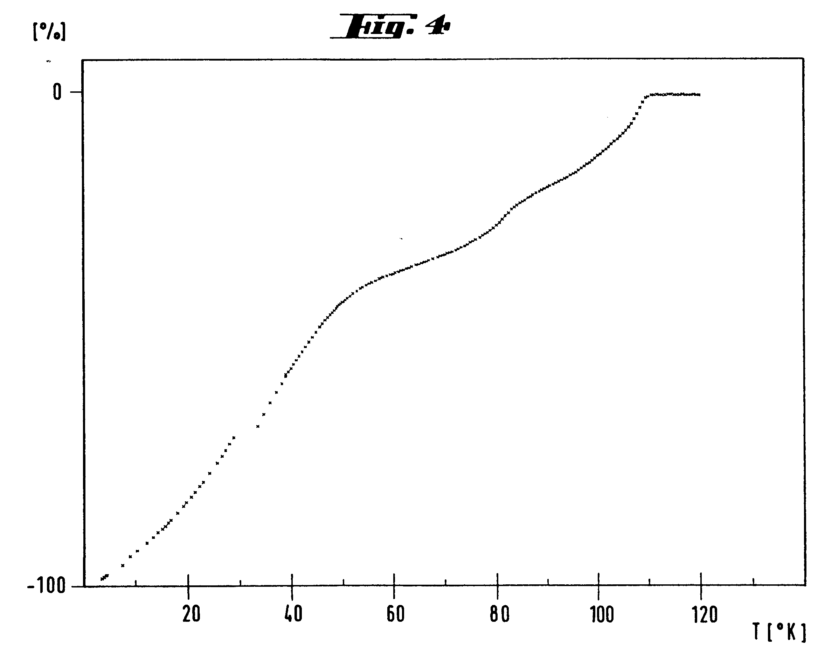

Beispiel 1 wurde wiederholt, jedoch mit einer Bruttozusammensetzung des Ausgangsgemisches von $Bi_{2,3}Sr_2Ca_2Cu_3O_x$. Der Anteil an 2223-Phase betrug weniger als 20 Vol.-% (Fig. 4).

Beispiel 4 (Vergleichsbeispiel)

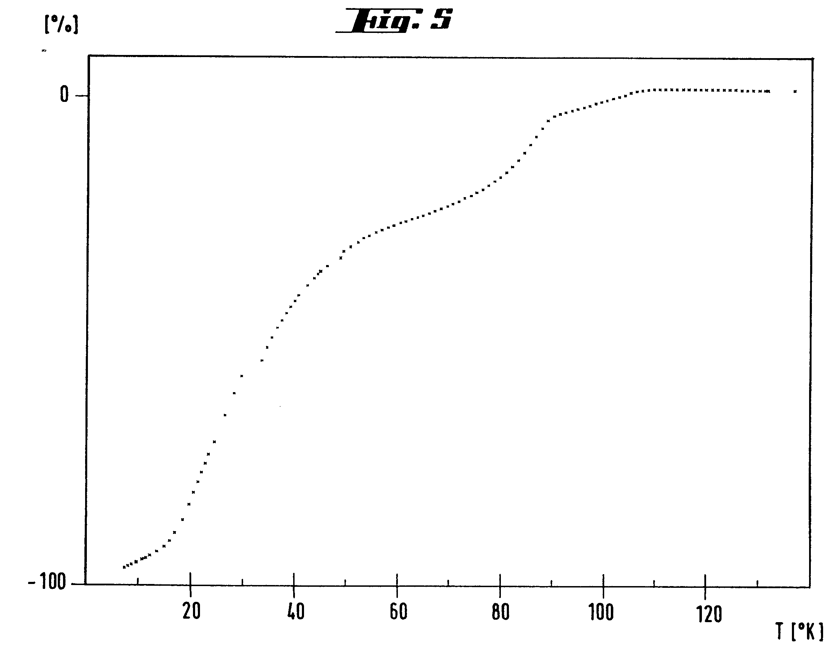

Ein ähnliches Ergebnis wie in Beispiel 3 wird auch erhalten, wenn die Zusammensetzung des Ausgangsgemisches identisch ist mit der formellen Zusammensetzung der 2223-Phase (Fig. 5).

Bedeutung der Figuren im einzelnen:

Fig. 1   Intensität der reflektierten Röntgenstrahlung (willkürliche Einheiten) über 2 $\theta$ (= Beugungswinkel) der nach Beispiel 1 erhaltenen Probe, gemessen bei einer Wellenlänge von 154,056 pm.

Fig. 2   Supraleitender Volumenanteil [in %] über der absoluten Temperatur T der nach Beispiel 1 erhaltenen Probe.

Fig. 3   Supraleitender Volumenanteil [in %] über T

Fig. 4 Supraleitender Volumenanteil [in %] über T der nach Beispiel 3 erhaltenen Probe $Bi_{2.3}Sr_2Ca_2Cu_3O_x$.

Fig. 5 Supraleitender Volumenanteil [in %] über T der nach Beispiel 4 erhaltenen Probe $Bi_2Sr_2Ca_2Cu_3O_x$.

**Patentansprüche**

**Patentansprüche für folgende Vertragsstaaten : AT, BE, CH, LI, DE, DK, FR, GB, IT, LU, NL, SE**

1. Oxidkeramisches supraleitendes Material, das Wismut, Strontium, Kalzium und Kupfer enthält, das eine Bruttozusammensetzung $Bi_yCa_2Sr_2Cu_3O_x$ besitzt, wobei y eine Zahl von 2,35 bis 2,6 bedeutet und x etwa 10 bis 12, das eine Sprungtemperatur $T_c$ oberhalb von 105 K und das einen Phasenanteil der Phase $Bi_2Sr_2Ca_2Cu_3O_x$ von mindestens 70 Vol.-% aufweist.

2. Oxidkeramisches supraleitendes Material nach Anspruch 1, dadurch gekennzeichnet, daß y eine Zahl im Bereich von 2,45 bis 2,55 bedeutet und daß der Phasenanteil der Phase $Bi_2Sr_2Ca_2Cu_3O_x$ oberhalb von 90 Vol.-% liegt.

3. Verfahren zur Herstellung eines Wismut enthaltenden supraleitenden Materials mit einem Phasenanteil der Phase $Bi_2Sr_2Ca_2Cu_3O_x$ von mindestens 70 Vol.-%, bei dem die Oxide oder die Oxidvorläufer von Wismut, Strontium, Kalzium und Kupfer über eine Zeitspanne von mehreren Stunden auf einer Temperatur im Bereich von 850 bis 890°C gehalten werden und bei dem die folgenden Atomverhältnisse eingehalten werden:

   Bi : Cu ≥ 2,35 : 3
   Ca : Sr = 0,9 bis 1,50
   $\Sigma$ (Sr+Ca) : Cu = 4,2 : 3 bis 4 : 3,33
   Bi : $\Sigma$ (Sr+Ca) = 2,35 : 4 bis 3,1 : 4.

4. Verfahren nach Anspruch 3, dadurch gekennzeichnet, daß das Gemisch der Oxide zunächst mindestens 2 Stunden bei 700 - 800°C erhitzt und dann nach dem Abkühlen homogenisiert wird.

5. Verfahren nach Anspruch 4, dadurch gekennzeichnet, daß das homogenisierte Reaktionsprodukt mindestens 2 Stunden bei 800 - 860°C erhitzt und dann nach dem Abkühlen homogenisiert wird.

6. Verfahren nach Anspruch 5, dadurch gekennzeichnet, daß das erhaltene Pulver zu einem Formkörper verpreßt und dieser bei 860 bis 890°C gesintert wird.

7. Verfahren nach Anspruch 3, dadurch gekennzeichnet, daß das Material nach dem Erhitzen auf 860 bis 890°C im Ofen abgekühlt wird.

8. Verfahren nach Anspruch 4, dadurch gekennzeichnet, daß mindestens 50 Stunden bei 700 - 800°C erhitzt wird.

9. Verfahren nach Anspruch 5, dadurch gekennzeichnet, daß mindestens 50 Stunden bei 830°C erhitzt wird.

10. Supraleitender Formkörper mit einer Bruttozusammensetzung $Bi_yCa_2Sr_2Cu_3O_x$, wobei y eine Zahl von 2,35 bis 2,6 bedeutet und x etwa 10 bis 12 ist, und wobei das Material des Körpers eine Sprungtempertatur $T_c$ oberhalb von 105 K und einen Phasenanteil der Phase $Bi_2Sr_2Ca_2Cu_3O_x$ von mindestens 70 Vol.-% aufweist.

11. Supraleitender Formkörper nach Anspruch 10, dadurch gekennzeichnet, daß y eine Zahl von 2,45 bis 2,55 bedeutet.

12. Supraleitender Formkörper nach Anspruch 10 oder 11, dadurch gekennzeichnet, daß er einen Phasenanteil der Phase $Bi_2Sr_2Ca_2Cu_3O_x$ von mindestens 90 Vol.-% aufweist.

**Patentansprüche für folgende Vertragsstaaten : ES, GR**

1. Verfahren zur Herstellung eines Wismut enthaltenden supraleitenden Materials mit einem Phasenanteil der Phase $Bi_2Sr_2Ca_2Cu_3O_x$ von mindestens 70 Vol.-%, bei dem die Oxide oder die Oxidvorläufer von Wismut, Strontium, Kalzium und Kupfer über eine Zeitspanne von mehreren Stunden auf einer Temperatur im Bereich von 850 bis 890°C gehalten werden und bei dem die folgenden Atomverhältnisse eingehalten werden:

   Bi : Cu ≥ 2,35 : 3
   Ca : Sr = 0,9 bis 1,50
   $\Sigma$ (Sr + Ca) : Cu = 4,2 : 3 bis 4 : 3,33
   Bi : $\Sigma$ (Sr + Ca) = 2,35 : 4 bis 3,1 : 4.

2. Verfahren nach Anspruch 1, dadurch gekennzeichnet, daß das Gemisch der Oxide zunächst mindestens 2 Stunden bei 700 - 800°C erhitzt und dann nach dem Abkühlen homogenisiert wird.

3. Verfahren nach Anspruch 2, dadurch gekennzeichnet, daß das homogenisierte Reaktionsprodukt mindestens 2 Stunden bei 800 - 860°C erhitzt und dann nach dem Abkühlen homogenisiert wird.

4. Verfahren nach Anspruch 3, dadurch gekennzeichnet, daß das erhaltene Pulver zu einem Formkörper verpreßt und dieser bei 860 bis 890°C gesintert wird.

5. Verfahren nach Anspruch 1, dadurch gekennzeichnet, daß das Material nach dem Erhitzen auf 860 bis 890°C im Ofen abgekühlt wird.

6. Verfahren nach Anspruch 2, dadurch gekennzeichnet, daß mindestens 50 Stunden bei 700 - 800°C erhitzt wird.

7. Verfahren nach Anspruch 3, dadurch gekennzeichnet, daß mindestens 50 Stunden bei 830°C erhitzt wird.

8. Supraleitender Formkörper mit einer Bruttozusammensetzung $Bi_yCa_2Sr_2Cu_3O_x$, wobei y eine Zahl von 2,35 bis 2,6 bedeutet und x etwa 10 bis 12 ist, und wobei das Material des Körpers eine Sprungtemperatur $T_c$ oberhalb von 105 K und einen Phasenanteil der Phase $Bi_2Sr_2Ca_2Cu_3O_x$ von mindestens 70 Vol.-% aufweist.

9. Supraleitender Formkörper nach Anspruch 8, dadurch gekennzeichnet, daß y eine Zahl von 2,45 bis 2,55 bedeutet.

10. Supraleitender Formkörper nach Anspruch 8 oder 9, dadurch gekennzeichnet, daß er einen Phasenanteil der Phase $Bi_2Sr_2Ca_2Cu_3O_x$ von mindestens 90 Vol.-% aufweist.

**Claims**

**Claims for the following Contracting States : AT, BE, CH, LI, DE, DK, FR, GB, IT, LU, NL, SE**

1. An oxide-ceramic superconducting material which contains bismuth, strontium, calcium and copper and has an overall composition of $Bi_yCa_2Sr_2Cu_3O_x$, where y is a number from 2.35 to 2.6 and x is about 10 to 12, and which has a critical temperature $T_c$ above 105 K and a proportion of the phase $Bi_2Sr_2Ca_2Cu_3O_x$ of at least 70% by volume.

2. An oxide-ceramic superconducting material as claimed in claim 1, wherein y is a number in the range from 2.45 to 2.55 and wherein the proportion of the phase $Bi_2Sr_2Ca_2Cu_3O_x$ is above 90% by volume.

3. A process for producing a bismuth-containing super-conducting material having a proportion of the phase $Bi_2Sr_2Ca_2Cu_3O_x$ of at least 70% by volume, which comprises holding the oxides or the oxide precursors of bismuth, strontium, calcium and copper at a temperature in the range from 850 to 890°C over a time span of a plurality of hours and adhering to the following atomic ratios:

Bi : Cu ≥ 2.35 : 3
Ca : Sr = 0.9 to 1.50
Σ (Sr + Ca) : Cu = 4.2 : 3 to 4 : 3.33
Bi : Σ (Sr + Ca) = 2.35 : 4 to 3.1 : 4.

4. The process as claimed in claim 3, wherein the mixture of oxides is first heated for at least 2 hours at 700 - 800°C and then homogenized after cooling.

5. The process as claimed in claim 4, wherein the homogenized reaction product is heated for at least 2 hours at 800 - 860°C and then homogenized after cooling.

6. The process as claimed in claim 5, wherein the powder obtained is compressed to form a molding and the latter is sintered at 860 to 890°C.

7. The process as claimed in claim 3, wherein the material is cooled after heating at 860 to 890°C in the furnace.

8. The process as claimed in claim 4, wherein heating is carried out for at least 50 hours at 700 - 800°C.

9. The process as claimed in claim 5, wherein heating is carried out for at least 50 hours at 830°C.

10. A superconducting molding having an overall composition of $Bi_yCa_2Sr_2Cu_3O_x$, where y is a number from 2.35 to 2.6 and x is about 10 to 12, the material of the molding having a critical temperature $T_c$ above 105 K and a proportion of the phase $Bi_2Sr_2Ca_2Cu_3O_x$ of at least 70% by volume.

11. A superconducting molding as claimed in claim 10, wherein y is a number from 2.45 to 2.55.

12. A superconducting molding as claimed in claim 10 or 11, which has a proportion of the phase $Bi_2Sr_2Ca_2Cu_3O_x$ of at least 90% by volume.

**Claims for the following Contracting States : ES, GR**

1. A process for producing a bismuth-containing super-conducting material having a proportion of the phase $Bi_2Sr_2Ca_2Cu_3O_x$ of at least 70% by volume, which comprises holding the oxides or the oxide precursors of bismuth, strontium, calcium and copper at a temperature in the range from 850 to 890°C over a time span of a plurality of hours and adhering to the following atomic ratios:

Bi : Cu ≥ 2.35 : 3
Ca : Sr = 0.9 to 1.50
Σ (Sr + Ca) : Cu = 4.2 : 3 to 4 : 3.33
Bi : Σ (Sr + Ca) = 2.35 : 4 to 3.1 : 4.

2. The process as claimed in claim 1, wherein the mixture of oxides is first heated for at least 2 hours at 700 - 800°C and then homogenized after cooling.

3. The process as claimed in claim 2, wherein the homogenized reaction product is heated for at least 2 hours at 800 - 860°C and then homogenized after cooling.

4. The process as claimed in claim 3, wherein the powder obtained is compressed to form a molding and the latter is sintered at 860 to 890°C.

5. The process as claimed in claim 1, wherein the material is cooled after heating at 860 to 890°C in the furnace.

6. The process as claimed in claim 2, wherein heating is carried out for at least 50 hours at 700 - 800°C.

7. The process as claimed in claim 3, wherein heating is carried out for at least 50 hours at 830°C.

8. A superconducting molding having an overall composition of $Bi_yCa_2Sr_2Cu_3O_x$, where y is a number from 2.35 to 2.6 and x is about 10 to 12, the material of the molding having a critical temperature $T_c$ above 105 K and a proportion of the phase $Bi_2Sr_2Ca_2Cu_3O_x$ of at least 70% by volume.

9. A superconducting molding as claimed in claim 8, wherein y is a number from 2.45 to 2.55.

10. A superconducting molding as claimed in claim 8 or 9, which has a proportion of the phase $Bi_2Sr_2Ca_2Cu_3O_x$ of at least 90% by volume.

**Revendications**

**Revendications pour les Etats contractants suivants : AT, BE, CH, LI, DE, DK, FR, GB, IT, LU, NL, SE**

1. Matériau supraconducteur céramique à base d'oxydes contenant du bismuth , du strontium, du calcium et du cuivre, ayant une composition brute $Bi_yCa_2Sr_2Cu_3O_x$, y représentant un nombre de 2,35 à 2,6 et x d'environ 10 à 12, qui a une température critique $T_c$ supérieure à 105 K et présente un taux phasique de la phase $Bi_2Sr_2Ca_2Cu_3O_x$ d'au moins 70 % en volume.

2. Matériau supraconducteur céramique à base d'oxydes selon la revendication 1, caractérisé en ce que y est un nombre dans l'intervalle de 2,45 à 2,55 et le taux phasique de la phase $Bi_2Sr_2Ca_2Cu_3O_x$ est supérieur à 90 % en volume.

3. Procédé pour la préparation de matériaux supraconducteurs contenant du bismuth ayant un taux phasique de la phase $Bi_2Sr_2Ca_2Cu_3O_x$ d'au moins

70 % en volume dans lequel on maintient les oxydes ou les précurseurs d'oxydes de bismuth , de strontium, de calcium et de cuivre, pendant plusieurs heures à une température dans l'intervalle de 850 à 890 °C et dans lequel on maintient les rapports atomiques suivants :

Bi:Cu ≥ 2,35:3
Ca:Sr = 0,9 à 1,50
$\Sigma$(Sr+Ca):Cu = 4,2:3 à 4:3,33
Bi:$\Sigma$(Sr+Ca) = 2,35:4 à 3,1:4.

4. Procédé selon la revendication 3, caractérisé en ce que l'on chauffe d'abord le mélange des oxydes pendant au moins 2 heures à 700 à 800 °C et ensuite ,on l'homogénéise après refroidissement.

5. Procédé selon la revendication 4, caractérisé en ce que l'on chauffe le produit de réaction homogénéisé pendant au moins 2 heures à 800 à 860 °C et ensuite on l'homogénéise après refroidissement.

6. Procédé selon la revendication 5, caractérisé en ce que l'on comprime la poudre obtenue pour obtenir un corps façonné et on le fritte à une température de 860 à 890 °C.

7. Procédé selon la revendication 3, caractérisé en ce que l'on refroidit le matériau dans le four, après l'avoir chauffé à une température de 860 à 890 °C.

8. Procédé selon la revendication 4, caractérisé en ce que l'on chauffe pendant au moins 50 heures à une température de 700 à 800 °C.

9. Procédé selon la revendication 5, caractérisé en ce que l'on chauffe à 830 °C pendant au moins 50 heures.

10. Corps moulé supraconducteur ayant une composition brute $Bi_yCa_2Sr_2Cu_3O_x$, où y est un nombre de 2,35 à 2,6 et x d'environ 10 à 12, et le matériau du corps ayant une température critique $T_c$ supérieure à 105 K, et qui présente un taux phasique de la phase $Bi_2Sr_2Ca_2Cu_3O_x$ d'au moins 70 % en volume.

11. Corps moulé supraconducteur selon la revendication 10, caractérisé en ce que y va de 2,45 à 2,55.

12. Corps moulé supraconducteur selon la revendication 10 ou 11, caractérisé en ce qu'il présente un taux phasique de la phase $Bi_2Sr_2Ca_2Cu_3O_x$ d'au moins 90 % en volume.

**Revendications pour les Etats contractants suivants : ES, GR**

1. Procédé pour la préparation d'un matériau supraconducteur contenant du bismuth , ayant un taux phasique de la phase $Bi_2Sr_2Ca_2Cu_3O_x$ d'au moins 70 % en volume, dans lequel on maintient les oxydes ou les précurseurs d'oxydes de bismuth , de strontium, de calcium et de cuivre pendant plusieurs heures à une température dans l'intervalle de 850 à 890 °C et dans lequel on maintient les rapports atomiques suivants :

Bi:Cu ≥ 2,35:3
Ca:Sr = 0,9 à 1,50
$\Sigma$(Sr+Ca):Cu = 4,2:3 à 4:3,33
Bi:$\Sigma$(Sr+Ca) = 2,35:4 à 3,1:4.

2. Procédé selon la revendication 1, caractérisé en ce que l'on chauffe d'abord le mélange des oxydes pendant au moins 2 heures à 700 à 800 °C et ensuite, on l'homogénéise après refroidissement.

3. Procédé selon la revendication 2, caractérisé en ce que l'on chauffe le produit de réaction homogénéisé pendant au moins 2 heures à 800 à 860 °C et ensuite on l'homogénéise après refroidissement.

4. Procédé selon la revendication 3, caractérisé en ce que l'on comprime la poudre obtenue pour obtenir un corps façonné et on le fritte à une température de 860 à 890 °C.

5. Procédé selon la revendication 1, caractérisé en ce que l'on refroidit le matériau dans le four après l'avoir chauffé à une température de 860 à 890 °C.

6. Procédé selon la revendication 2, caractérisé en ce que l'on chauffe pendant au moins 50 heures à une température de 700 à 800 °C.

7. Procédé selon la revendication 3, caractérisé en ce que l'on chauffe à 830 °C pendant au moins 50 heures.

8. Corps moulé supraconducteur ayant une composition brute $Bi_yCa_2Sr_2Cu_3O_x$, où y représente un nombre de 2,35 à 2,6 et x d'environ 10 à 12, et le matériau du corps ayant une température critique $T_c$ supérieure à 105 K, et qui présente un taux phasique de la phase $Bi_2Sr_2Ca_2Cu_3O_x$ d'au moins 70 % en volume.

9. Corps moulé supraconducteur selon la revendication 8, caractérisé en ce que y va de 2,45 à 2,55.

10. Corps moulé supraconducteur selon la revendication 8 ou 9, caractérisé en ce qu'il présente un taux phasique de la phase $Bi_2Sr_2Ca_2Cu_3O_x$ d'au moins 90 % en volume.

_Fig. 1_

EP 0 504 840 B1

Fig. 2

[%]

**Fig. 3**

0

-90

20   40   60   80   100   120

T [°K]

Fig. 4

Fig. 5

EP 0 504 840 B1